(19) Europäisches Patentamt
European Patent Office
Office européen des brevets

(11) EP 0 508 174 B1

(12) EUROPÄISCHE PATENTSCHRIFT

(45) Veröffentlichungstag und Bekanntmachung des Hinweises auf die Patenterteilung:
**03.09.1997 Patentblatt 1997/36**

(51) Int Cl.$^6$: **G03F 7/004**

(21) Anmeldenummer: **92104744.5**

(22) Anmeldetag: **19.03.1992**

(54) **Strahlungsempfindliches Gemisch, enthaltend säurelabile Gruppierungen und Verfahren zur Herstellung von Reliefmustern und Reliefbildern**

Radiation sensitive mixture, containing groups which are labile in acid environment and method for fabrication of relief patterns and relief images

Composition sensible aux rayonnements, contenant des groupes labiles en milieu acide et procédé de fabrication d'images et de modèles en relief

(84) Benannte Vertragsstaaten:
**DE FR IT**

(30) Priorität: **08.04.1991 DE 4111283**

(43) Veröffentlichungstag der Anmeldung:
**14.10.1992 Patentblatt 1992/42**

(73) Patentinhaber: **BASF Aktiengesellschaft**
**67063 Ludwigshafen (DE)**

(72) Erfinder:
- **Schwalm, Reinhold, Dr.**
  **W-6706 Wachenheim (DE)**
- **Binder, Horst**
  **W-6840 Lampertheim (DE)**
- **Funhoff, Dirk, Dr.**
  **W-6900 Heidelberg (DE)**

(56) Entgegenhaltungen:
**EP-A- 0 342 494** **EP-A- 0 388 813**

- **MICROELECTRONIC ENGINEERING Bd. 13, Nr. 1/4, März 1991, AMSTERDAM,NL Seiten 33 - 36; SCHLEGEL ET AL.: 'HIGHLY SENSITIVE POSITIVE DEEP UV RESIST UTILIZING A SULFONATE ACID GENERATOR AND A TETRAHYDROPYRANYL INHIBITOR'**

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist. (Art. 99(1) Europäisches Patentübereinkommen).

EP 0 508 174 B1

## Beschreibung

Die Erfindung betrifft positiv arbeitende strahlungsempfindliche Gemische, die ein wäßrig-alkalisch lösliches Bindemittel, eine Verbindung, die mindestens eine durch Säure spaltbare Bindung enthält und unter Einwirkung von Strahlung eine starke Säure bildet, wobei die Löslichkeit der Verbindung in einem alkalischen Lösungsmittel durch die Einwirkung der Säure erhöht wird, sowie weitere die Lagerfähigkeit, bzw. den Verarbeitungsspielraum verbessernde Verbindungen enthalten. Diese Gemische sind sensitiv gegenüber UV-, Elektronen- und Röntgenstrahlen und eignen sich besonders als Resistmaterialien.

Positiv arbeitende strahlungsempfindliche Gemische sind bekannt. Positiv arbeitende Resistmaterialien, die o-Chinondiazide in wäßrig-alkalischen Bindemitteln, z.B. Novolake enthalten, werden kommerziell als Photoresiste eingesetzt, so daß auch die Verfahren zur Herstellung von Reliefbildern bekannt sind. Die Empfindlichkeit dieser Systeme gegenüber Strahlung ist jedoch teilweise unbefriedigend.

Daher hat man strahlungsempfindliche Systeme entwickelt, welche in der Primärphotoreaktion eine Spezies erzeugen, die dann unabhängig von der Strahlung eine katalytische Sekundärreaktion auslösen und dadurch die Empfindlichkeiten drastische erhöhen. Solche Systeme, die photochemisch eine starke Säure erzeugen, die dann in einer Sekundärreaktion säurelabile Gruppen spaltet, sind z.B. aus US-PS 3 932 514, US-PS 3 915 706, und DE-A 34 06 927 bekannt.

Als solche photochemisch säureerzeugenden Verbindungen sind beispielsweise Oniumsalze, Halogenverbindungen, Nitrobenzylsulfonate und Sulfonsäureester von Phenolen (vgl. Proceedings of the International Symposium on Polymers for Microelectronics (1990) für Positivresists, und SPIE, Advances in Resist Technology and Processing VII, Seite 26ff. (1990) für Negativresists) bekannt. In dem Artikel über die Positivresists werden die Vorteile der Sulfonsäureester gegenüber den Oniumsalzen dargestellt, z.B. wird beschrieben, daß die Positivresistformulierungen bei Verwendung von Oniumsalzen bei 2- bis 3-facher Überbelichtung negativ arbeitend werden, bei Verwendung der Sulfonsäureester jedoch selbst bei 10-facher Überbelichtung kein Negativverhalten zeigen.

Weiterhin werden in der DE-A 37 21 741 strahlungsempfindliche Gemische vorgeschlagen, die ein in wäßrig-alkalischen Lösungen lösliches polymeres Bindemittel enthalten sowie eine organische Verbindung, deren Löslichkeit in einem wäßrig alkalischen Entwickler durch Einwirkung von Säure erhöht wird und die mindestens eine durch Säure spaltbare Gruppierung enthält, wobei die organische Verbindung unter Einwirkung von Strahlung eine starke Säure erzeugt.

Ein Nachteil aller dieser Systeme ist deren Empfindlichkeit gegenüber Lagerzeiten zwischen dem Verfahrensschritt Belichtung und dem darauf folgendem Prozeß der Sekundärreaktion zur Abspaltung der säurelabilen Gruppen, welche meist durch Ausheizen unterstützt wird. Längere Lagerzeiten zwischen den Prozeßschritten Belichtung und Ausheizen nach der Belichtung führen im allgemeinen zu verlängerten Entwicklungszeiten bzw. nichtentwickelbaren Restschichten.

Aufgabe der vorliegenden Erfindung war es, strahlungsempfindliche Gemische aufzuzeigen, mit denen man Photoresiste auf Basis säurekatalytischer Reaktionen, insbesondere lichtempfindlicher positiv arbeitender Beschichtungsmaterialien, bestehend aus in wäßrig-alkalischen Lösungen löslichem Bindemittel und einer organischer Verbindung, die mindestens eine durch Säure spaltbare Bindung und eine unter Einwirkung von Strahlung eine starke Säure bildende Gruppierung enthält, zu Reliefmustern verarbeiten kann, wobei ein praxisgerechter Verarbeitungsspielraum, insbesondere in bezug auf Lagerzeiten zwischen Belichtung und Ausheizschritten, ermöglicht wird.

Diese Aufgabe läßt sich überraschenderweise durch die erfindungsgemäßen Gemische sehr vorteilhaft lösen.

Gegenstand der vorliegenden Erfindung ist ein strahlungsempfindliches Gemisch, enthaltend

(a) ein in Wasser unlösliches, in wäßrig-alkalischen Lösungen lösliches polymeres Bindemittel und

(b) eine organische Verbindung, deren Löslichkeit in einem wäßrig-alkalischen Entwickler durch Einwirkung von Säure erhöht wird und die mindestens eine durch Säure spaltbare Gruppierung sowie zusätzlich eine Gruppierung, die unter Einwirkung von Strahlung eine starke Säure bildet, enthält, das dadurch gekennzeichnet ist, daß das strahlungsempfindliche Gemisch zusätzlich

(c) mindestens eine organische Verbindung der allgemeinen Formel (I)

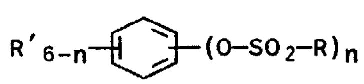

(I)

enthält, worin

R für Alkyl mit 1 bis 8 Kohlenstoffatomen, Halogenalkyl mit 1 bis 8 Kohlenstoffatomen, Aryl mit 6 bis 18 Kohlenstoffatomen, alkyl-, halogen- oder $NO_2$-substituiertes Aryl,

R' gleich oder verschieden und für Wasserstoff, Alkyl mit 1 bis 8 Kohlenstoffatomen, Alkoxi mit 1 bis 8 Kohlenstoffatomen oder

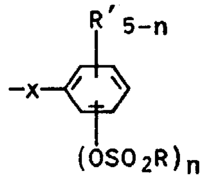

mit

x= -O-, -S- oder $-(-CR''_2)_m-$,

R" für H, Alkyl mit 1 bis 4 Kohlenstoffatomen oder Halogen,

n für 1, 2 oder 3 und

m für 0 bis 8 stehen.

Bevorzugt sind dabei strahlungsempfindliche Gemische mit polymeren Bindemitteln (a) auf Basis von Homo- oder Copolymeren des p-Hydroxistyrols und/oder p-Hydroxi-ω-methylstyrols. Als Comonomereinheiten kommen dabei besonders in o-Stellung zur Hydroxigruppe mono- oder disubstituierte Hydroxistyrole oder Hydroxistyrole, deren phenolische Gruppe mit säurelabilen Gruppierungen geschützt ist, in Frage.

Bevorzugt als organische Verbindungen (b) sind Sulfoniumsalze der allgemeinen Formel (II)

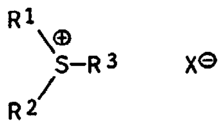

(II)

worin $R^1$, $R^2$ und $R^3$ untereinander gleich oder verschieden sind und für aliphatische und/oder aromatische Reste, die gegebenenfalls Heteroatome enthalten, stehen oder zwei der Reste $R^1$ bis $R^3$ miteinander zu einem Ring verknüpft sind, mit der Mapgabe, daß mindestens einer der Reste $R^1$ bis $R^3$ mindestens eine durch Säure spaltbare Gruppierung enthält, wobei einer der Reste $R^1$ bis $R^3$ mit einem oder mehreren weiteren Sulfoniumsalzresten, gegebenenfalls über durch Säure abspaltbare Gruppierungen, verknüpft sein kann, und $X^\ominus$ ein nichtnukleophiles Gegenion bedeutet.

Bevorzugte organische Verbindungen der allgemeinen Formel (I) sind die Sulfonsäurealkylester von Brenzkatechin, Resorcin, Hydrochinon, Pyrogallol, Phloroglucin und Hydroxihydrochinon.

Gegenstand der vorliegenden Erfindung ist außerdem ein Verfahren zur Herstellung von Reliefmustern und Reliefbildern, wobei ein erfindungsgemäßes strahlungsempfindliches Gemisch eingesetzt wird, das vorzugsweise nach der Belichtung auf Temperaturen zwischen 60°C und 120°C erhitzt wird.

Die erfindungsgemäßen strahlungsempfindlichen Gemische ermöglichen die Herstellung von Reliefmustern und Reliefbildern mit hoher Auflösung bei praxisgerechter Verarbeitbarkeit mit genügend großem Verarbeitungsspielraum, insbesondere mit tolerierbaren Lagerzeiten (> 10 Minuten) zwischen Belichtung und Ausheizschritt.

Weiterhin ist die Empfindlichkeit der Systeme durch die katalytische Wirkung der photochemisch erzeugten Säuren sehr hoch und es ergeben sich sehr hohe Kontrastwerte. Diese strahlungsempfindlichen Gemische sind daher für die Anwendung in der Deep-UV Lithographie sehr gut geeignet.

Zu den Aufbaukomponenten des erfindungsgemäßen strahlungsempfindlichen Gemisches ist im einzelnen folgendes auszuführen.

(a) Das polymere Bindemittel (a) besteht in einer besonders bevorzugten Ausführungsform im wesentlichen aus Polymeren auf Basis von Homo- oder Copolymeren des p-Hydroxistyrols und/oder p-Hydroxi-α-methylstyrols. Als Comonomereinheiten kommen dabei besonders in o-Stellung zur Hydroxigruppe mono- oder disubstituierte Hydroxistyrole oder Hydroxistyrole, deren phenolische Gruppe mit säurelabilen Gruppierungen geschützt ist, in Frage. Besonders bevorzugte säurelabile Gruppierungen sind dabei t-Alkylcarbonate, wie t-Butylcarbonate, t-Amylcarbonate, Ether und Acetale, wie t-Butylether, Tetrahydropyranylether und t-Butylester. Die Polymeren weisen im allgemeinen mittlere Molekulargewichte $\overline{M}_w$ zwischen 2.000 und 100.000, vorzugsweise zwischen 10.000 und 30.000 auf.

Das polymere Bindemittel (a) ist im erfindungsgemäßen Gemisch im allgemeinen in einer Menge von 55 bis 99, vorzugsweise 70 bis 97 Gew.-%, bezogen auf die Summe der Komponenten (a) bis (c), enthalten.

(b) Besonders bevorzugte organische Verbindungen (b) sind solche der allgemeinen Formel (II),

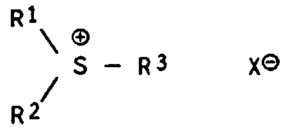

(II)

worin $R^1$, $R^2$ und $R^3$ untereinander gleich oder verschieden sind und für aliphatische und/oder aromatische Reste, die gegebenenfalls Heteroatome enthalten, stehen oder zwei der Reste $R^1$ bis $R^3$ miteinander zu einem Ring verknüpft sind, mit der Mapgabe, daß mindestens einer der Reste $R^1$ bis $R^3$ mindestens eine durch Säure spaltbare Gruppierung, vorzugsweise t-Butylcarbonate von Phenolen bzw. Silylether von Phenolen enthält, wobei einer der Reste $R^1$ bis $R^3$ mit einem oder mehreren weiteren Sulfoniumsalzresten, gegebenenfalls über durch Säure spaltbare Gruppierungen, verknüpft sein kann und $X^{\ominus}$ ein nichtnucleophiles Gegenion bedeutet.

Als Gegenionen kommen bevorzugt komplexe Metallhalogenide, wie Tetrafluoroborat, Hexafluoroantimonat, Hexafluoroarsenat, und starke organische Säureanionen wie Trifluormethansulfonat und Fluorsulfonat, in Frage.

Es können auch zwei oder mehrere Sulfoniumeinheiten im Molekül über die Reste $R^1$ bis $R^3$ verknüpft sein.

Bevorzugte Sulfoniumsalze der allgemeinen Formel (II)

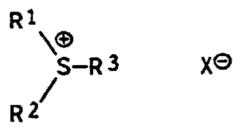

(II)

sind solche, in denen $R^1$ und $R^2$ für Methylgruppen und $R^3$ für substituierte Phenylderivate mit säurespaltbaren Gruppen stehen, z.B.

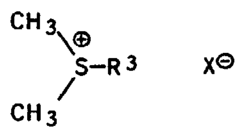

worin $R^3$ z.B. für 4-t-Butoxicarbonyloxi-phenyl-, 4-t-Butoxicarbonyloxi-3,5-dimethyl-phenyl-, 4-t-Butoxicarbonyloxi-3-methyl-phenyl-, 4-t-Butoxicarbonyloxi-2-methyl-phenyl-, 4-t-Butoxicarbonyloxi-3,5-dimethoxi-phenyl-, 4-t-Butoxicarbonyloxi-3,5-diphenyl-phenyl-, 1-t-Butoxicarbonyloxi-naphthyl-, 4-Trimethylsilyl-oxi-phenyl-, 4-Trimethylsilyl-oxi-naphthyl- stehen oder auch solche, in denen zwei der Reste $R^1$ bis $R^3$ miteinander zu einem Ring, insbesondere einem fünf-oder sechsgliedrigen Ring verknüpft sind, wobei z.B. $R^1$ und $R^2$ beispielsweise zu Tetramethylengruppen verbrückt sind und $R^3$ die gleiche Bedeutung wie vorstehend hat:

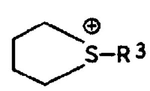

oder Verbindungen, in denen $R^1$ für Methyl und $R^2$ für Phenyl bzw. Tolyl stehen und $R^3$ für ein substituiertes Phenylderivat mit säurespaltbaren Gruppen steht, wie

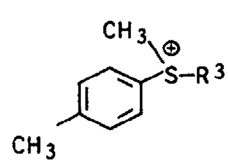

worin $R^3$, für 4-t-Butoxicarbonyloxi-phenyl-, 2,4-Di-t-butoxicarbonyloxiphenyl-, 4-t-Butoxicarbonyloxi-2-methoxi-phenyl-, 4-Trimethylsilylphenyl- steht,
oder worin $R^1$ für Phenyl oder $C_1$- bis $C_{12}$-alkyl-substituiertes Phenyl oder halogensubstituiertes Phenyl steht und $R^2$ und $R^3$ substituierte Phenylderivate mit säurespaltbaren Gruppen sind, wie z.B.

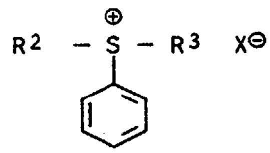

worin $R^2$ und $R^3$ z.B. 4-t-Butoxicarbonyloxi-phenyl, 4-Trimethylsilyloxiphenyl-, 4-t-Butyl-dimethyl-silyloxi-phenyl-, 4-t-Butoxicarbonyloxi-3,5-dimethyl-phenyl- oder $R^1$, $R^2$ und $R^3$ untereinander gleich sind, d.h. Sulfoniumsalze (b), in denen diese Reste mit säurespaltbaren Gruppen dreimal enthalten sind.

Weiterhin kommen auch Verbindungen der allgemeinen Formel (II) in Betracht, worin einer der Reste $R^1$ bis $R^3$ mit einem oder mehreren weiteren Sulfoniumsalzresten, gegebenenfalls über durch Säure spaltbare Gruppierungen verknüpft ist, die also ebenfalls mehrere Sulfoniumgruppen im Molekül aufweisen, wie z.B.

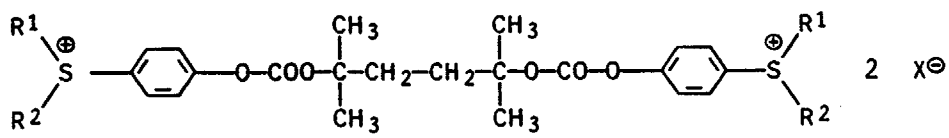

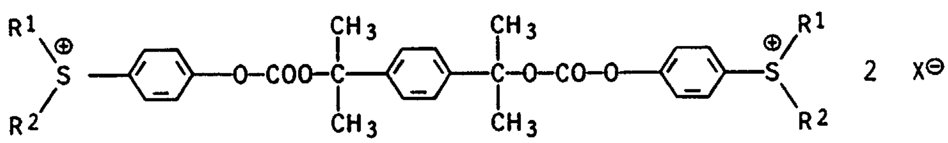

Die organischen Verbindungen (b) können nach den bekannten Methoden der organischen Chemie zur Synthese von Estern, Ethern und Carbonaten hergestellt werden, indem man von den Sulfoniumsalzen mit phenolischen Gruppen ausgeht und diese entsprechend derivatisiert. Ausgehend von Sulfoniumsalzen mit phenolischen Gruppen können diese mit Kalium-t-butylat umgesetzt werden, anschließend kann mit Di-t-butyl-dicarbonat die säurespaltbare Gruppe eingeführt oder alternativ das phenolische Sulfoniumsalz mit einer aktivierten Carbonylverbindung, z.B. dem t-Butyloxi-carbonyl-N-imidazol, umgesetzt werden. Für diese Umsetzung eignen sich insbesondere Hydroxiphenyl-sulfoniumsalze, die bereits ein nichtnucleophiles Anion, wie z.B. Hexafluoroantimonat, enthalten. Solche Verbindungen können beispielsweise nach einer Synthesevorschrift in J. Polym. Sci., Chem. Ed., 18, 1021 (1980), hergestellt werden. Man kann beispielsweise die so hergestellten Verbindungen in trockenem Tetrahydrofuran lösen, Kalium-t-butylat in trockenem Tetrahydrofuran zugeben und anschließend eine Lösung von Di-t-butyl-dicarbonat in Tetrahydrofuran zutropfen. Nach der Aufarbeitung und Umkristallisation erhält man die reinen Sulfoniumsalze mit säurelabilen Gruppen.

Bevorzugte Beispiele für organische Verbindungen (b) sind Dimethyl-4-t-butoxicarbonyloxiphenyl-sulfoniumsalze mit Hexafluoroarsenat, Hexafluoroantimonat, Hexafluorophosphat, Hexafluoroborat oder Trifluormethansulfonat als Gegenion, Phenyl-bis-(4-t-butoxicarbonyloxiphenyl-)sulfoniumsalz mit den genannten Gegenionen. Tris-(4-t-butoxicarbonyloxiphenyl-)sulfoniumsalze mit den genannten Gegenionen oder 1-Naphthyl-4-trimethylsilyloxitetramethylen-sulfoniumsalze mit den genannten Gegenionen.

Die organischen Verbindungen (b) sind im erfindungsgemäßen Gemisch im allgemeinen in einer Menge von 0,5 bis 20, vorzugsweise 2 bis 15 Gew.-%, bezogen auf die Summe der Komponenten (a) bis (c), enthalten.
(c) Als organische Verbindungen kommen Sulfonsäureester der allgemeinen Formel (I)

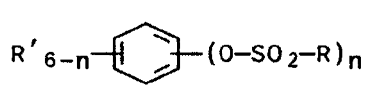 (I)

in Frage, worin

R für Alkyl mit 1 bis 8 Kohlenstoffatomen, beispielsweise Methyl, Ethyl, Propyl, i-Propyl, Butyl, i-Butyl, Pentyl, Hexyl und 2-Ethylhexyl,
für Halogenalkyl mit 1 bis 8 Kohlenstoffatomen, wie Mono-, Di- oder Trichlormethyl und Trifluormethyl,
für Aryl mit 6 bis 18 Kohlenstoffatomen, beispielsweise Phenyl oder Naphthyl,
für alkyl- (mit 1 bis 8 Kohlenstoffatomen im Alkylrest), halogen-(z.B. Fluor, Chlor, Brom) oder $NO_2$-substituiertes Aryl, wie z.B. Alkylphenyl, Halogenphenyl, Nitrophenyl,

R' gleich oder verschieden und für Wasserstoff, Alkyl mit 1 bis 8 Kohlenstoffatomen, beispielsweise wie unter R genannt, für Halogenalkyl mit 1 bis 8 Kohlenstoffatomen, beispielsweise Trifluormethyl, Mono-, Di- oder Trichlormethyl, für Alkoxi mit 1 bis 8 Kohlenstoffatomen, beispielsweise Methoxi, Ethoxi, Propoxi, Butoxi,

oder

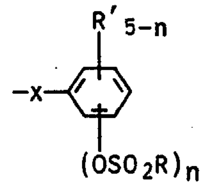

mit

x= -O-, -S- oder $-(-CR''_2)_m-$,
R" für H, Alkyl mit 1 bis 4 Kohlenstoffatomen, wie z. B. Methyl, oder Halogen, wie z.B. Fluor,
n für 1, 2 oder 3 und
m für 0 bis 8 stehen.

Bevorzugte organische Verbindungen (c) sind Alkylsulfonsäure- und Arylsulfonsäureester von Hydroxyaromaten, beispielsweise:

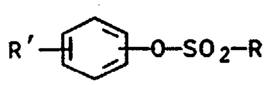 , 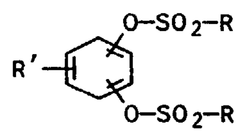 ,

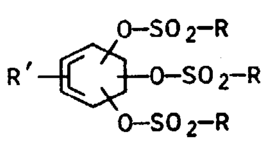 , 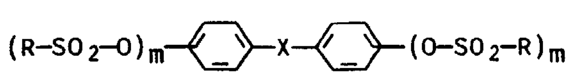

mit

m = 1 oder 2 und
X = O, S oder $CR''_2$ und
R und R' wie oben definiert
R" = H, Alkyl mit 1 bis 4 Kohlenstoffatomen oder Halogen z.B. Chlor)

Auch Gemische der genannten organischen Verbindungen (c) sind geeignet.

Die organischen Verbindungen (c) sind im erfindungsgemäßen strahlungsempfindlichen Gemisch in einer Menge von 0,5 bis 25, vorzugsweise 1 bis 15 Gew.%, bezogen auf die Gesamtmenge der Komponenten (a) + (b) + (c), enthalten.

Durch den Zusatz der organischen Verbindung (c) können alle strahlungsempfindlichen Gemische, welche auf Mischungen von säurelabile Gruppen enthaltenden Polymeren und Oniumsalzen, bzw. alkalilöslichen Polymeren, säurelabile Gruppen enthaltenden niedermolekularen organischen Verbindungen und Oniumsalzen basieren, in ihrem Verarbeitungsspielraum zwischen Belichtung und Ausheizen verbessert werden.

Bei dem erfindungsgemäßen Verfahren zur Herstellung von Reliefmustern und Reliefbildern wird eine strahlungsempfindliche Aufzeichnungsschicht, die im wesentlichen aus dem erfindungsgemäßen strahlungsempfindlichen Gemisch besteht, das zweckmäßigerweise in einem inerten Lösungsmittel, wie z.B. Methyl-propylenglykolacetat, Methylcellosolveacetat oder Ethylcellosolveacetat gelöst, in üblicher Weise, beispielsweise durch Aufschleudern (spin coating) auf ein geeignetes Substrat, wie z.B. einen Siliciumwafer, in Schichtdicken (trocken gemessen) von 0,2 bis 4 µm aufgetragen und getrocknet wurde, bildmäßig in solcher Dosis bestrahlt und bei Temperaturen von 60 bis 120°C während 5 Sekunden bis 5 Minuten ausgeheizt, so daß die Löslichkeit der belichteten Bereiche in wäßrig-alkalischen Lösungsmitteln, beispielsweise alkalischen Entwicklern von pH 10-14, enthaltend Alkali-hydroxide, Alkalisilikate oder Amine, wie Tetramethylammonium-hydroxid, zunimmt und diese bestrahlten Bereiche selektiv mit dem alkalischen Entwickler entfernt werden können.

Die Gemische weisen hohe Empfindlichkeit und Kontraste auf. Es entstehen Reliefstrukturen guter Strukturqualität.

Weitere Angaben über Zusammensetzung und Weiterverarbeitung strahlungsempfindlicher Gemische können beispielsweise auch der DE-A 37 21 741 entnommen werden.

Die in den Beispielen genannten Teile und Prozente sind, soweit nicht anders angegeben, Gewichtsteile und Gewichtsprozente.

Beispiele

Beispiel 1

Eine Photoresistlösung wird aus 15 Teilen Tris-(4-t-butoxycarbonyloxiphenyl-)sulfoniumtrifluormethansulfonat, 5 Teilen 1,2,3-Tris(methansulfonyloxy)benzol, 80 Teilen Poly-(p-vinylphenol) und 300 Teilen Methyl-propylenglykol-acetat hergestellt. Die Lösung wird anschließend durch ein Filter mit einem Porendurchmesser von 0,2 µm filtriert.

Diese Resistlösung wird auf einen Siliciumwafer mit einem $SiO_2$-Film in einer Schichtdicke von ca. 1 µm aufgeschleudert. Der Wafer wird eine Minute bei 90°C getrocknet, anschließend mit einer bildmäßig strukturierten Testmaske in Kontakt gebracht und 3 Sekunden mit Excimer-Laserlicht der Wellenlänge 248 nm belichtet.

Dann läßt man den Wafer 1 Stunde liegen (21°C, rel. Raumfeuchte 45 %), um eventuell auftretende Wartezeiten zwischen den einzelnen Prozeßschritten zu simulieren.

Anschließend wird der Wafer 1 Minute bei 90°C ausgeheizt und mit einem alkalischen Entwickler entwickelt. Der Wafer läßt sich einwandfrei zu einem positiven Reliefmuster entwickeln und zeigt die gleiche Strukturgüte wie ein Vergleichswafer, der direkt nach der Belichtung ausgeheizt wurde.

Selbst bei 10facher Belichtungsenergie ist kein Negativverhalten zu beobachten.

Vergleichsbeispiel 1:

Es wird wie in Beispiel 1 verfahren, jedoch enthält die Resistlösung kein Tris(methansulfonyloxi)benzol, stattdessen 85 Teile Polymer. Nach einer Stunde Lagerzeit zwischen Belichtung und Ausheizen ist das Resistmuster mit dem in Beispiel 1 verwendeten Entwickler nicht mehr entwickelbar.

Beispiel 2

Eine Photoresistlösung wird aus 5 Teilen Tris-(4-t-butoxycarbonyloxiphenyl-)sulfoniumtrifluormethansulfonat, 90 Teilen Poly-(p-vinylphenol)-co-p-t-butoxicarbonyloxi-styrol) 9 : 1 (= Poly-(p-hydroxistyrol), dessen phenolische Hydroxylgruppen zu 10 % durch t-Butoxicarbonylgruppen geschützt sind), , 5 Teilen 1,2,3-Tris(methansulfonyloxi)benzol und 300 Teilen Cyclohexanon hergestellt. Die Lösung wird anschließend durch ein Filter mit einem Porendurchmesser von 0,2 µm filtriert.

Diese Resistlösung wird auf einen Siliciumwafer in einer Schichtdicke von ca. 1 µm aufgebracht und 1 Minute bei 90°C auf einer Heizplatte ausgeheizt. Dann belichtet man bildmäßig durch eine strukturierte Testmaske im Kontaktverfahren während 4 Sekunden mit Excimer-Laserlicht der Wellenlänge 248 nm.

Nach dem Belichten wird die eine Hälfte des Wafers sofort 1 Minute lang bei 90°C ausgeheizt und mit einem alkalischen Entwickler entwickelt. Nach 33 Sekunden Entwicklungszeit sind die mit 90 $mJ/cm^2$ belichteten Bereiche vollständig abgetragen.

Die andere Hälfte des Wafers wird 15 Minuten nach der Belichtung in normaler Raumluft liegenlassen, dann 1

Minute bei 90°C ausgeheizt und entwickelt. Die Entwicklungszeit beträgt ebenfalls 33 Sekunden.

Vergleichsbeispiel 2

Es wird eine Resistformulierung wie in Beispiel 2 verwendet, jedoch enthält die Resistformulierung kein Sulfoniumtrifluormethansulfonat, stattdessen 95 Teile Polymer. Es wird wie in Beispiel 2 beschichtet, ausgeheizt und belichtet. Die eine Hälfte des Wafers wird sofort ausgeheizt. Dabei beträgt die Entwicklungszeit bei 90 $mJ/cm^2$ Belichtung 34 Sekunden. Die andere Hälfte des Wafers bleibt 15 Minuten nach Belichtung liegen und wird erst dann ausgeheizt. Dadurch verlängert sich die Entwicklungszeit auf 62 Sekunden.

Vergleichsbeispiel 3:

Es wird eine Resistformulierung wie in Beispiel 2 verwendet, jedoch enthält die Resistformulierung kein 1,2,3-Tris (methansulfonyloxi)benzol, stattdessen 95 Teile Polymer. Es wird wie in Beispiel 2 beschichtet, ausgeheizt und belichtet. Die eine Hälfte des Wafers wird sofort ausgeheizt. Dabei beträgt die Entwicklungszeit bei 90 $mJ/cm^2$ Belichtung 34 Sekunden. Die andere Hälfte des Wafers bleibt 15 Minuten nach Belichtung liegen und wird erst dann ausgeheizt. Dadurch verlängert sich die Entwicklungszeit auf 78 Sekunden.

Beispiel 3:

Es wird wie in Beispiel 1 verfahren, jedoch wird anstatt des 1,2,3-Tris(methansulfonyloxi)benzols, 1,2,3-Tris(ethansulfonyloxi)benzol eingesetzt. Die Entwicklungsergebnisse sind identisch mit denen des Beispiels 1.

Beispiel 4 bis 6

Es wird wie in Beispiel 2 verfahren, jedoch werden folgende Verbindungen (c) eingesetzt.

| Verbindung (c) | Lagerzeit |
|---|---|
| (4) 5 % 1,3,5-Tris(methansulfonyloxi)benzol | 15 Min |
| (5) 5 % 1,2-Bis(methansulfonyloxi)benzol | 20 Min |
| (6) 5 % 1,2,3-Tris(toluolsulfonyloxi)benzol | 20 Min. |

Bis zu den angegebenen Lagerzeiten sind keine Veränderungen im Entwicklungsverhalten zu beobachten, und alle Resistmuster nach einem Ausheizschritt von 1 Minute bei 90°C noch rückstandsfrei entwickelbar.

Ohne die Zusätze c) treten bereits nach 10 Minuten Restschichten auf.

Beispiel 7

Es wird eine Photoresistlösung aus 10 Teilen Dimethyl-4-t-butoxicarbonyloxiphenyl-sulfonium-hexafluoroarsenat, 86 Teilen Poly(vinylphenol-co-p-t-amyloxicarbonyloxi-styrol) 9 : 1 (= Poly-(p-hydroxistyrol), dessen phenolische Hydroxylgruppen zu 10 % durch t-Amyloxicarbonylgruppen geschützt sind), 4 Teilen 1,2-Di(methansulfonyloxi)benzol und 300 Teilen Ethyllactat hergestellt und durch ein Filter mit einer Porenweite von 0,2 µm filtriert.

Die Resistlösung wird in einer Schichtdicke von ca. 1 µm auf einen Wafer aufgebracht und bildmäßig belichtet. Man kann anschließend bis zu 15 Minuten lagern, ohne daß sich das Entwicklungsverhalten ändert, während ein Vergleichswafer ohne den Sulfonsäureester innerhalb der Entwicklungszeit von 60 Sekunden nicht mehr durchentwikkelt werden kann.

## Patentansprüche

**1.** Strahlungsempfindliches Gemisch, enthaltend

(a) ein in Wasser unlösliches, in wäßrig-alkalischen Lösungen lösliches polymeres Bindemittel und

(b) eine organische Verbindung, deren Löslichkeit in einem wäßrigalkalischen Entwickler durch Einwirkung von Säure erhöht wird und die mindestens eine durch Säure spaltbare Gruppierung sowie zusätzlich eine Gruppierung, die unter Einwirkung von Strahlung eine starke Säure bildet, enthält,

dadurch gekennzeichnet, daß das strahlungsempfindliche Gemisch zusätzlich (c) mindestens eine organische Verbindung der allgemeinen Formel (I)

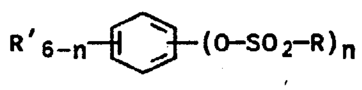

(I)

enthält, worin

R für Alkyl mit 1 bis 8 Kohlenstoffatomen, Halogenalkyl mit 1 bis 8 Kohlenstoffatomen, Aryl mit 6 bis 18 Kohlenstoffatomen, alkyl-, halogen- oder $NO_2$-substituiertes Aryl,

R' gleich oder verschieden und für Wasserstoff, Alkyl mit 1 bis 8 Kohlenstoffatomen, Alkoxi mit 1 bis 8 Kohlenstoffatomen oder

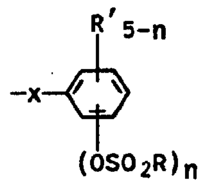

mit

x= -O-, -S- oder $-(-CR''_2)_m-$,

R" für H, Alkyl mit 1 bis 4 Kohlenstoffatomen oder Halogen,

n für 1, 2 oder 3 und

m für 0 bis 8 stehen.

**2.** Strahlungsempfindliches Gemisch nach Anspruch 1, dadurch gekennzeichnet, daß die organische Verbindung (b) ein Sulfoniumsalz der allgemeinen Formel (II) ist

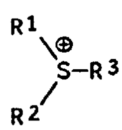

$X^{\ominus}$ (II)

worin $R^1$, $R^2$ und $R^3$ untereinander gleich oder verschieden sind und für aliphatische und/oder aromatische Reste, die gegebenenfalls Heteroatome enthalten, stehen oder zwei der Reste $R^1$ bis $R^3$ miteinander zu einem Ring verknüpft sind, mit der Maßgabe, daß mindestens einer der Reste $R^1$ bis $R^3$ mindestens eine durch Säure spaltbare Gruppierung enthält, wobei einer der Reste $R^1$ bis $R^3$ mit einem oder mehreren weiteren Sulfoniumsalzresten, gegebenenfalls über durch Säure abspaltbare Gruppierungen, verknüpft sein kann, und $X^{\ominus}$ ein nichtnukleophiles Gegenion bedeutet.

**3.** Strahlungsempfindliches Gemisch nach Anspruch 1 oder 2, dadurch gekennzeichnet, daß als organische Verbindung (c) der allgemeinen Formel (I) Sulfonsäurealkylester von Brenzcatechin, Resorcin, Hydrochinon, Pyrogallol, Phloroglucin und/oder Hydroxyhydrochinon eingesetzt werden.

**4.** Strahlungsempfindliches Gemisch nach einem der vorhergehenden Ansprüche, dadurch gekennzeichnet, daß die organische Verbindung (c) in einer Menge von 0,5 bis 25 Gew.-%, bezogen auf die Gesamtmenge des strahlungsempfindlichen Gemisches (a) + (b) + (c), enthalten ist.

**5.** Strahlungsempfindliches Gemisch nach einem der vorhergehenden Ansprüche, dadurch gekennzeichnet, daß Komponente (b) im strahlungsempfindlichen Gemisch in einer Menge von 0,5 bis 20 Gew.-%, bezogen auf die Gesamtmenge des strahlungsempfindlichen Gemisches (a) + (b) + (c), enthalten ist.

**6.** Verfahren zur Herstellung von Reliefmustern und Reliefbildern, dadurch gekennzeichnet, daß man als lichtempfindliche Beschichtungsmaterialien ein strahlungsempfindliches Gemisch gemäß einem der vorhergehenden Ansprüche einsetzt.

7. Verfahren zur Herstellung von Reliefmustern nach Anspruch 6, dadurch gekennzeichnet, daß nach der Belichtung des strahlungsempfindlichen Gemisches auf Temperaturen zwischen 60 und 120°C erhitzt wird.

## Claims

1. A radiation-sensitive mixture containing

   (a) a polymeric binder which is insoluble in water but soluble in aqueous alkaline solutions and
   (b) an organic compound whose solubility in an aqueous alkaline developer is increased by the action of an acid and which contains one or more groups cleavable by an acid and in addition a group which forms a strong acid under the action of radiation,

   wherein the radiation-sensitive mixture additionally contains
   (c) one or more organic compounds of the formula (I)

   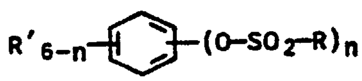 (I)

   where R is alkyl of 1 to 8 carbon atoms, haloalkyl of 1 to 8 carbon atoms, aryl of 6 to 18 carbon atoms or alkyl-, halogen- or $NO_2$-substituted aryl, the radicals R' are identical or different and are each hydrogen, alkyl of 1 to 8 carbon atoms, alkoxy of 1 to 8 carbon atoms or

   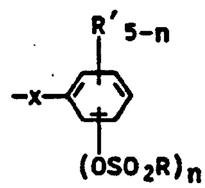

   where
   X is -O-, -S- or $-(-CR''_2)_m-$, R" is H, alkyl of 1 to 4 carbon atoms or halogen, n is 1, 2 or 3 and m is from 0 to 8.

2. A radiation-sensitive mixture as claimed in claim 1, wherein the organic compound (b) is a sulfonium salt of the formula (II)

   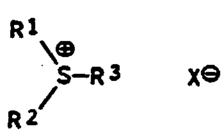 (II)

   where $R^1$, $R^2$ and $R^3$ are identical or different and are aliphatic and/or aromatic radicals which may contain hetero atoms, or two of the radicals $R^1$ to $R^3$ are bonded to one antoher to form a ring, with the proviso that one or more of the radicals $R^1$ to $R^3$ contain one or more groups cleavable by an acid, and one of the radicals $R^1$ to $R^3$ may be bonded to one or more further sulfonium salt radicals, if necessary via groups cleavable by an acid, and $X^{\ominus}$ is a nonnucleophilic counter-ion.

3. A radiation-sensitive mixture as claimed in claim 1 or 2, wherein an alkyl sulfonate of pyrocatechol, resorcinol, hydroquinone, pyrogallol, phloroglucinol and/or hydroxyhydroquinone is used as the organic compound (c) of the formula (I).

**4.** A radiation-sensitive mixture as claimed in any of the preceding claims, wherein the organic compound (c) is present in an amount of from 0.5 to 25% by weight, based on the total amount of radiation-sensitive mixture (a) + (b) + (c).

**5.** A radiation-sensitive mixture as claimed in any of the preceding claims, wherein component (b) is present in the radiation-sensitive mixture in an amount of from 0.5 to 20% by weight, based on the total amount of radiation-sensitive mixture (a) + (b) + (c).

**6.** A process for the production of a relief pattern or relief image, wherein the photosensitive coating material used is a radiation-sensitive mixture as claimed in any of the preceding claims.

**7.** A process for the production of a relief pattern as claimed in claim 6, wherein exposure of the radiation-sensitive mixture is followed by heating at from 60 to 120°C.

**Revendications**

**1.** Mélange sensible aux rayonnements, contenant

**a)** un liant polymère insoluble dans l'eau mais soluble dans les solutions aqueuses alcalines et
**b)** un composé organique dont la solubilité dans un révélateur aqueux alcalin est accrue sous l'action d'un acide et qui contient au moins un groupement scindable sous l'action des acides et en outre un groupement qui forme un acide fort sous l'action d'un rayonnement,

caractérisé par le fait que le mélange sensible aux rayonnements contient en outre (c) au moins un composé organique de formule générale I

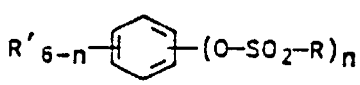

(I)

dans laquelle

R représente un groupe alkyle en C1-C8, halogénoalkyle en C1-C8, aryle en C6-C18, aryle portant des substituants alkyles, halogéno ou $NO_2$,
les symboles R', ayant des significations identiques ou différentes, représentent chacun l'hydrogène, un groupe alkyle en C1-C8, alcoxy en C1-C8 ou

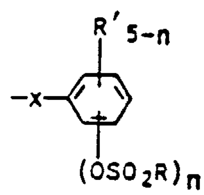

dans lequel

x = -O-, -S- ou $-(-CR''_2)_m-$,
R"représente H, un groupe alkyle en C1-C4 ou un halogène,
n est égal à 1, 2 ou 3 et
m est un nombre allant de 0 à 8.

**2.** Mélange sensible aux rayonnements selon la revendication 1, caractérisé par le fait que le composé organique b) est un sel de sulfoniumde formule générale II

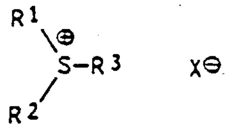

(II)

dans laquelle $R^1$, $R^2$ et $R^3$, ayant des significations identiques ou différentes, représentent chacun un radical aliphatique et/ou aromatique contenant le cas échéant des hétéroatomes, ou bien deux des groupes $R^1$ à $R^3$ sont reliés entre eux avec formation d'un cycle, sous réserve que l'un au moins des radicaux $R^1$ à $R^3$ contient au moins un groupement scindable sous l'action des acides, l'un des groupes $R^1$ à $R^3$ pouvant être relié à un ou plusieurs autres radicaux de sels de sulfonium, le cas échéant par l'intermédiaire de groupements scindables sous l'action des acides, et $X^{\ominus}$ représente un ion complémentaire non nucléophile.

**3.** Mélange sensible aux rayonnements selon la revendication 1 ou 2, caractérisé par le fait que l'on utilise en tant que composé organique (c) de formule générale I un ester d'acide alkylsulfonique du pyrocatéchol, du résorcinol, de l'hydroquinone, du pyrogallol, du phloroglucinol et/ou de l'hydroxyhydroquinone.

**4.** Mélange sensible aux rayonnements selon une des revendications qui précèdent, caractérisé par le fait que le mélange sensible aux rayonnements a + b + c contient le composé organique (c) en quantité de 0,5 à 25 % de son poids total.

**5.** Mélange sensible aux rayonnements selon une des revendications qui précèdent, caractérisé par le fait que, dans le mélange sensible aux rayonnements, le composant b) est contenu en proportions de 0,5 à 20 % du poids total du mélange sensible aux rayonnements a + b + c.

**6.** Procédé pour former des modèles en relief et des images en relief, caractérisé par le fait que l'on utilise en tant que matériau de revêtement sensible à la lumière un mélange sensible aux rayonnements selon l'une des revendications qui précèdent.

**7.** Procédé pour former des modèles en relief selon la revendication 6, caractérisé par le fait que, après exposition à la lumière, on chauffe le mélange sensible aux rayonnements à des températures de 60 à 120° C.